# EUROPEAN PATENT APPLICATION

(11) **EP 4 456 334 A1**
(43) Date of publication of application: **30.10.2024**
(21) Application number: 23170797.7
(22) Date of filing: 28.04.2023
(51) Int. Cl.: H01R 12/78

(54) **FOIL TO FOIL CONNECTOR**

(71) Applicant: Airbus Operations GmbH, 21129 Hamburg (DE)
(72) Inventor: Brückmann, Konstantin, Hamburg (DE); Hahn, Dennis, Hechthausen (DE); Caspari, Jana, Hamburg (DE); Nitsche, Maximilian, Hamburg (DE)
(74) Representative: Schornack, Oliver

(57) **Abstract**

The present disclosure relates to a connector (1) for enabling an electrical connection between a first flexible carrier (21) with electrically conductive tracks (221) on its principal surface and a second flexible carrier (22) with electrically conductive tracks (222) on its principal surface. The connector (1) comprises a connector base part (11) having a first planar shape and being configured to accommodate a first surface of the first flexible carrier (21) opposed to the principal surface of the first flexible carrier (21), and a connector locking part (12) having a second planar shape and being configured to accommodate a second surface of the second flexible carrier (22) opposed to the principal surface of the second flexible carrier (22), wherein, in a closed state of the connector (1), the electrically conductive tracks (221, 222) of the first and second flexible carriers (21, 22) are urged to contact one another and are fixated in a defined position. (Fig. 1)

## Description

### Technical Field

The present disclosure generally relates to a foil-to-foil connector. In particular, the present disclosure relates to a foil-to-foil connector in the fields of cabin/cargo electronics, printed electronics and data transfer, e.g. in civil/military aviation. In addition, the connector may also be used to connect flexible printed circuits (FPCs).

### Background

Currently, there already are different connectors employing a variety of connection principles. However, the shape of such connectors in general and attachment of the connector to the foil in particular do not yet meet the requirements pertaining to printed electrics.

### Summary

Accordingly, there is a need for an implementation of a scheme that avoids one or more of the problems discussed above, or other related problems.

These objects are solved by the present invention as defined by the independent claim. Preferred embodiments are defined by the dependent claims.

Without loss of generality, the present disclosure can be summarized as follows. A connector enables an electrical connection between two flexible foils. In this regard, the printed electric conductive tracks on each foil will be pressed against each other and will be fixated in a defined position. A vehicle component, such as an aircraft component, may require an electrical connection, which is achieved by the connector. For instance, one flexible foil of the two flexible foils can be provided in or on the vehicle component and can be connected to the other flexible foil by the connector.

In addition, the present disclosure enables the following advantages:
- A universal connector concept for a wide range of use is attained.
- Adjustment of the connector to panel/foil thickness is possible.
- A simple click and snap concept to integrate the connector to the module/conductive tracks and the panel/foil is provided.
- An homogeneous contact force will be realized e.g. by a pressure sensitive fleece to ensure a minimum of contact resistance.

In a first aspect to better understand the present disclosure, there is provided a connector for enabling an electrical connection between a first flexible carrier with electrically conductive tracks on its principal surface and a second flexible carrier with electrically conductive tracks on its principal surface. The connector comprises a connector base part having a first planar shape and being configured to accommodate a first surface of the first flexible carrier opposed to the principal surface of the first flexible carrier; and a connector locking part having a second planar shape and being configured to accommodate a second surface of the second flexible carrier opposed to the principal surface of the second flexible carrier, wherein, in a closed state of the connector, the electrically conductive tracks of the first and second flexible carriers are urged to contact one another and are fixated in a defined position.

In an implementation variant, in an open state of the connector, the first and second flexible carriers preferably are placeable into the defined position. The connector base part preferably comprises a first deformable layer laminated on a first rigid shell layer and the connector locking part preferably comprises a second deformable layer laminated on a second rigid shell layer. In the closed state, the first deformable layer and the second deformable layer preferably face one another, and a respective reactive force of the deformed first and second deformable layers preferably causes the electrically conductive tracks of the first and second flexible carriers to be urged to contact one another. Moreover, in the closed state, the first and second deformable layers preferably define a space in-between them that is dimensioned, in a direction of thickness, to press-fit the first and second flexible carriers.

In another implementation variant, the connector base part preferably comprises a first end portion and a second end portion opposite to the first end portion, the connector locking part preferably comprises a third end portion and a fourth end portion opposite to the third end portion, and the connector preferably further comprises a locking mechanism configured to lock, by means of the first to fourth end portions, the connector base part and the connector locking part in the closed state of the connector.

In a first refinement of the first aspect, the locking mechanism preferably comprises a snap-fit comprised in the first end portion, the snap-fit protruding towards the second end portion, a recess comprised in the third end portion, the recess being configured to engage with the snap-fit in the closed state of the connector, and a hinge consisting of the second end portion and the fourth end portion pivotably engaging one another. In the open state of the connector, the snap-fit preferably does not engage with the recess, and the hinge is preferably configured to swivel the connector locking part away from the connector base part. In addition, the recess preferably has an elongated form, and the snap-fit preferably has an elongated form substantially matching the elongated form of the recess.

In a second refinement of the first aspect, the locking mechanism preferably comprises a first guiding means comprised in the first end portion, a second guiding means parallel to the first guiding means, the second guiding means being comprised in the second end portion, a first elongated protrusion comprised in the third end portion, the first elongated protrusion being configured to slidably engage the first guiding means, and a second elongated protrusion comprised in the fourth end portion, the second elongated protrusion being configured to slidably engage the second guiding means. The first and second guiding means preferably both are one of a groove and a setback. The connector base part is preferably longer than the connector locking part in a longitudinal direction of the first and second guiding means, and the connector locking part preferably is slidably movable with respect to the connector base part in a sliding direction parallel to the longitudinal direction. In addition, the first deformable layer preferably covers only a portion of the connector base part; and in the open state of the connector, the connector locking part preferably is slidably displaced in the sliding direction from the portion of the connector base part covered by the first deformable layer, whereas in the closed state of the connector, the connector locking part is preferably placed above the portion of the connector base part covered by the first deformable layer.

In a second aspect to better understand the present disclosure, a vehicle component, such as a component of an aircraft, a train, a bus, a ship or other passenger may require an electrical connection. As a mere example, the vehicle component may have an electrically driven element, such as a switch, sensor, display panel, touchscreen, touch-sensitive input device, gesture sensing device, illumination, signals, or the like. The vehicle component can then be electrically connected by the connector of the first aspect or one of its variants.

For example, the first or second flexible carrier, according to the first aspect, can be arranged on or in the vehicle component. The other of the first and second flexible carrier can be arranged near an installation position of the vehicle component, so that the connector can be used to connect first and second flexible carriers.

In an implementation variant, the vehicle component is a lining, ceiling panel, sidewall, signage, monument wall, passenger seat, or floor element.

In another implementation variant, two vehicle components can be electrically connected to one another. In this case, the first flexible carrier is arranged on or in a first vehicle component, while the second flexible carrier is arranged on or in a second vehicle component, that are installed in the vehicle adjacent to one another.

In yet another implementation variant, the connector can be at least partially integrated into the vehicle component. As a mere example, the connector base part could be integrated into the vehicle component, i.e. is provided and/or formed on a surface of the vehicle component.

Concerning all aspects, variants and refinements, the first and second deformable layers preferably both are pressure-sensitive fleece layers. The first and second planar shapes of the connector base part and connector locking part preferably mean a rectangular form where both width and length are substantially larger than thickness, respectively. Moreover, the first and second flexible carriers preferably both are one of a flexible foil and a flexible printed circuit, FPC.

### Brief Description of the Drawings

The embodiments of the technique presented herein are described herein below with reference to the accompanying drawings, in which:
Fig. 1 shows a schematic drawing of a generic example arrangement of the apparatus according to the present disclosure;
Fig. 2 shows an overview of the apparatus according to a first embodiment of the present disclosure;
Fig. 3A shows an overview of the apparatus according to a first implementation of a second embodiment of the present disclosure;
Fig. 3B shows an overview of the apparatus according to a second implementation of the second embodiment of the present disclosure; and
Fig. 4 shows a model manufactured according to the second implementation of the second embodiment of the present disclosure.

### Detailed Description

In the following description, for purposes of explanation and not limitation, specific details are set forth in order to provide a thorough understanding of the technique presented herein. It will be apparent to one skilled in the art that the present technique may be practiced in other embodiments that depart from these specific details.

Moreover, those skilled in the art will appreciate that the services, functions and steps explained herein may be implemented using software functioning in conjunction with a programmed microprocessor, or using an Application Specific Integrated Circuit (ASIC), a Digital Signal Processor (DSP) or general purpose computer. It will also be appreciated that while the following embodiments are described in the context of methods and devices, the technique presented herein may also be embodied in a computer program product as well as in a system comprising a computer processor and a memory coupled to the processor, wherein the memory is encoded with one or more programs that execute the services, functions and steps disclosed herein. This applies especially to the aspect of an automated injection moulding process for manufacturing the connector of the present disclosure.

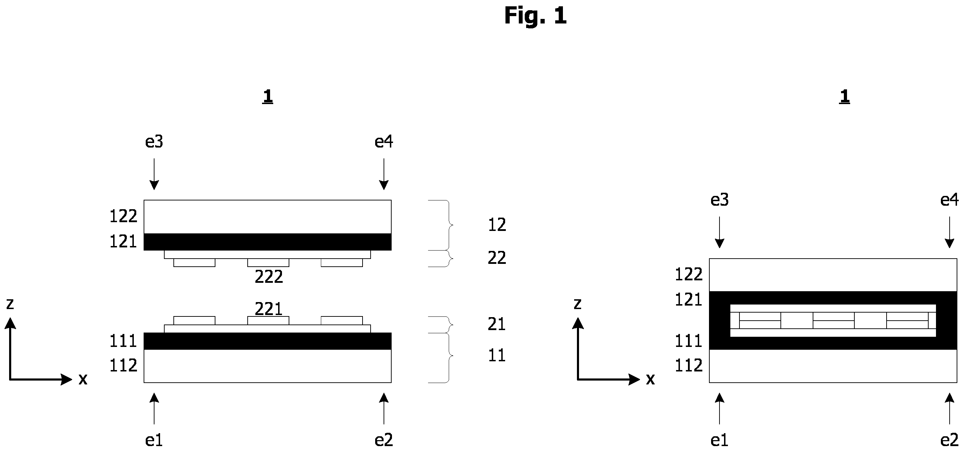

Fig. 1 shows a schematic drawing of a generic example arrangement of the apparatus according to the present disclosure. The left portion of Fig. 1 shows a connector (apparatus) 1 in its open state, whereas the right portion of Fig. shows the connector 1 in its closed state.

In general terms, the connector 1 aims at enabling an electrical connection between a first flexible carrier 21 with electrically conductive tracks 221 on its principal surface and a second flexible carrier 22 with electrically conductive tracks 222 on its principal surface. The connector 1 comprises a connector base part 11 having a first planar shape and being configured to accommodate a first surface of the first flexible carrier 21 opposed to the principal surface of the first flexible carrier 21, and a connector locking part 12 having a second planar shape and being configured to accommodate a second surface of the second flexible carrier 22 opposed to the principal surface of the second flexible carrier 22.

Notably, as indicated by the coordinate system in Fig. 1 (as well as in all other figures), the first and second planar shapes of the connector base part 11 and connector locking part 12 preferably mean a rectangular form where both width x and length y are substantially larger than thickness z, respectively.

As is shown in the right portion of Fig. 1, in the closed state of the connector 1, the electrically conductive tracks 221, 222 of the first and second flexible carriers 21, 22 are urged to contact one another and are fixated in a defined position. In other words, once the connector 1 is closed, the first and second deformable layers (e.g. pressure sensitive layers) 111, 121 squeezes the flexible carriers (e.g. two foils) 21, 22 together. Conversely, as is shown in the left portion of Fig. 1, in an open state of the connector 1, the first and second flexible carriers 21, 22 preferably are placeable into the defined position.

In addition, the connector base part 11 preferably comprises a first deformable layer 111 laminated on a first rigid shell layer 112 and the connector locking part 12 preferably comprises a second deformable layer 121 laminated on a second rigid shell layer 122. In other words, the connector itself is comparatively rigid/stiff.

In this regard, in the closed state, the first deformable layer 111 and the second deformable layer 112 preferably face one another, and a respective reactive force of the deformed first and second deformable layers 111, 121 preferably causes the electrically conductive tracks 221, 222 of the first and second flexible carriers 21, 22 to be urged to contact one another.

In this regard, the first and second deformable layers 111, 121 preferably both are pressure-sensitive fleece layers. In other words, a pressure sensitive layer 111, 121 will be embedded on the two parts of the connector, i.e., the connector base part 11 and the connector locking part 12. Notably, as is seen in the right portion of Fig. 1, as indicated by the first and second deformable layers 111, 121 depicted in black and (substantially) enclosing the first and second flexible carriers 21, 22, the conductive tracks 221, 222 will preferably close a circuit and the edges of the first and second deformable layers (e.g. pressure sensitive pads) 111, 121 will preferably seal the resulting connection area against humidity and moisture.

In other words, in the closed state, the first and second deformable layers 111, 121 preferably define a space in-between them that is dimensioned, in a direction of thickness z, to press-fit the first and second flexible carriers 21, 22.

Moreover, the general term first and second flexible carriers 21, 22 may relate to a usage of a flexible foil, but also encompasses a flexible printed circuit, FPC.

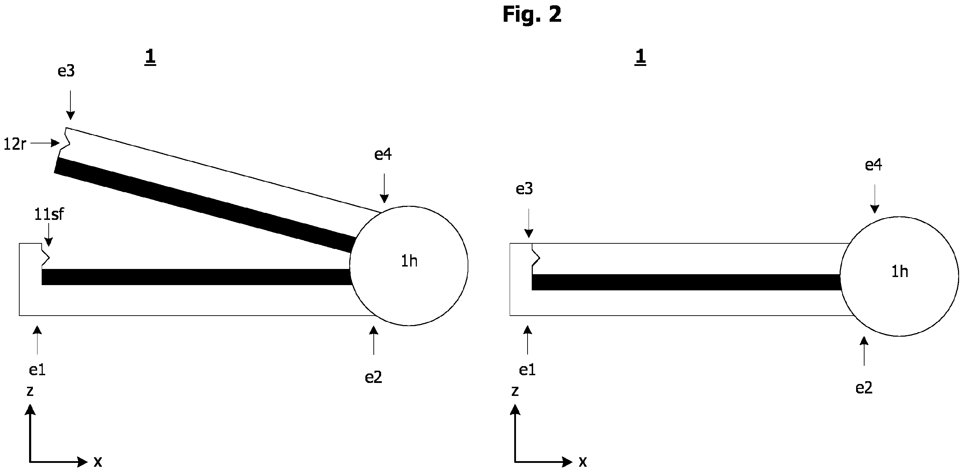

Fig. 2 shows an overview of the apparatus (connector 1) according to a first embodiment of the present disclosure. As is the case for Fig. 1, the left portion of Fig. 2 shows the connector 1 in its open state, whereas the right portion of Fig. 2 shows the connector 1 in its closed state. Notably, the flexible carriers 21, 22 were omitted for ease of depiction, but Fig. 2 is still to express that the flexible carriers 21, 22 are press-fit between the first and second deformable layers 111, 121.

In the first embodiment, the connector base part 11 preferably comprises a first end portion e1 and a second end portion e2 opposite to the first end portion e1, the connector locking part 12 preferably comprises a third end portion e3 and a fourth end portion e4 opposite to the third end portion e3, and the connector 1 preferably further comprises a locking mechanism 11sf, 12r, 1h configured to lock, by means of the first to fourth end portions e1 to e4, the connector base part 11 and the connector locking part 12 in the closed state of the connector 1.

In more concrete terms, the locking mechanism 11sf, 12r, 1h preferably comprises a snap-fit 11sf comprised in the first end portion e1, the snap-fit 11sf protruding towards the second end portion e2, a recess 12r comprised in the third end portion e3, the recess 12r being configured to engage with the snap-fit 11sf in the closed state of the connector 1, and a hinge 1h consisting of the second end portion e2 and the fourth end portion e4 pivotably engaging one another.

Conversely, as is shown in the left portion of Fig. 2, in the open state of the connector 1, the snap-fit 11sf preferably does not engage with the recess 12r, and the hinge 1h preferably is configured to swivel the connector locking part 12 away from the connector base part 11. In this way, in the open state with the connector locking part 12 swivelled away from the connector base part 11, it is particularly convenient to place the flexible carriers 21, 22 on the deformable layer 111 of the connector base part 11.

Moreover, the recess 12r preferably has an elongated form (in the y-direction perpendicular to the paper plane of Fig. 2), and the snap-fit 11sf has an elongated form substantially matching the elongated form of the recess 12r. In this way, in the closed state (shown in the right portion of Fig. 2), the pressure exerted on the flexible carriers 21, 22 becomes more uniform.

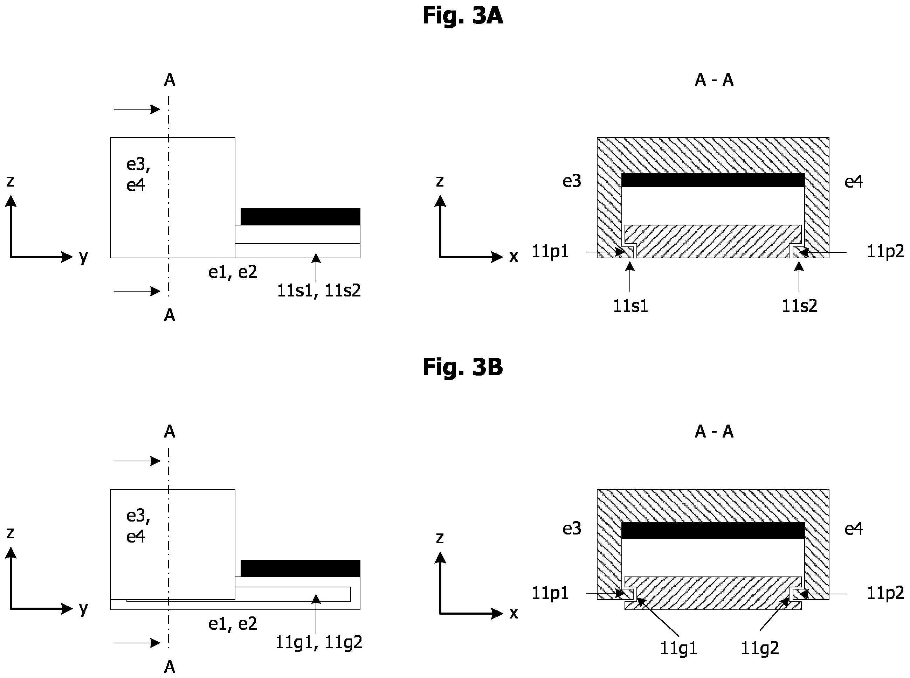

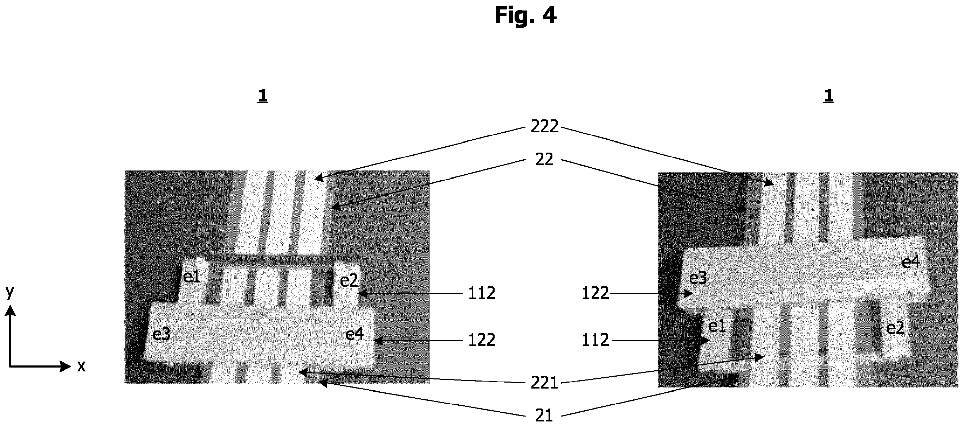

Fig. 3A shows an overview of the apparatus (connector 1) according to a first implementation of a second embodiment of the present disclosure. The left portion of Fig. 3A shows the connector 1 in its open state in side view, whereas the right portion of Fig. 3A shows a cut-out view of the connector 1 along the line A-A in the left portion of Fig. 3A. Fig. 3B shows an overview of the apparatus (connector 1) according to a second implementation of the second embodiment of the present disclosure. The left portion of Fig. 3B shows the connector 1 in its open state in side view, whereas the right portion of Fig. 3B shows a cut-out view of the connector 1 along the line A-A in the left portion of Fig. 3B. Notably, the flexible carriers 21, 22 were omitted for ease of depiction, but Figs. 3A and 3B are still to express that the flexible carriers 21, 22 are press-fit between the first and second deformable layers 111, 121. To give a deeper understanding of the second embodiment, Fig. 4 shows a model manufactured according to the second implementation of the second embodiment in top view.

Also in the second embodiment, the connector base part 11 preferably comprises a first end portion e1 and a second end portion e2 opposite to the first end portion e1, the connector locking part 12 preferably comprises a third end portion e3 and a fourth end portion e4 opposite to the third end portion e3, and the connector 1 preferably further comprises a locking mechanism 11sf, 12r, 1h configured to lock, by means of the first to fourth end portions e1 to e4, the connector base part 11 and the connector locking part 12 in the closed state of the connector 1.

In more concrete terms, as is seen in the respective right portion of Figs. 3A and 3B, the locking mechanism 11s1, 11s2, 11p1, 11p2 preferably comprises a first guiding means 11g1, 11s1 comprised in the first end portion e1 and a second guiding means 11g2, 11s2 parallel to the first guiding means 11g1, 11s1, the second guiding means 11g2, 111s2 being comprised in the second end portion e2, a first elongated protrusion 11p1 comprised in the third end portion e3, the first elongated protrusion 11p1 being configured to slidably engage the first guiding means 11g1, 11s1, and a second elongated protrusion 11p2 comprised in the fourth end portion e4, the second elongated protrusion 11p2 being configured to slidably engage the second guiding means 11g2, 11s2. Preferably, the first and second guiding means 11g1, 11g2, 11s1, 11s2 preferably both are one of a groove 11g1, 11g2 (see Fig. 3B) and a setback 11s1, 11s2 (see Fig. 3A).

Moreover, the connector base part 11 preferably is longer than the connector locking part 12 in a longitudinal direction (e.g. the y-direction in Figs. 3A and 3B) of the first and second guiding means 11g1, 11g2, 11s1, 11s2, and the connector locking part 12 is preferably slidably movable with respect to the connector base part 11 in a sliding direction parallel to the longitudinal direction.

On the one hand, the implementation of Fig. 3A involving the setbacks 11s1, 11s2 allows for simpler manufacture, as only one relevant margin between setback and protrusion must be observed (see Fig. 3A, right portion), at the expense of a lesser guiding effect on the connector locking part 12. Notably, Fig. 3A shows the setbacks 11s1, 11s2 without stops against which the protrusion 11p1, 11p2 can abut to ensure that the connector locking part 12 does not slide too far, but such stops can of course be provided.

On the other hand, the implementation of Fig. 3B involving the grooves 11g1, 11g2 requires more elaborate manufacturing, since two relevant margins between groove and protrusion must be observed (see Fig. 3B, right portion), with the advantage of an improved guiding effect on the connector locking part 12. Notably, Fig. 3B shows the grooves 11g1, 11g2 with stops against which the protrusion 11p1, 11p2 can abut to ensure that the connector locking part 12 does not slide too far, but such stops can of course also be omitted.

Finally, as is best seen in Fig. 4, the first deformable layer 111 covers only a portion of the connector base part 11, and in the open state of the connector 1, the connector locking part 12 is slidably displaced in the sliding direction from the portion of the connector base part 11 covered by the first deformable layer 111, whereas in the closed state of the connector 1, the connector locking part 12 is placed above the portion of the connector base part 11 covered by the first deformable layer 111.

As a mere example, the a first flexible carrier 21 can be arranged on or in a vehicle component (not explicitly illustrated), while the second flexible carrier 22 can be arranged adjacent to the vehicle component. For instance, the second flexible carrier 22 can be arranged in or on another vehicle component to be installed next to the (first) vehicle component associated with the first flexible carrier 21. Thus, the connector 1 can enable an electrical connection between the first and second flexible carriers 21, 22 associated with the respective vehicle components.

It is believed that the advantages of the technique presented herein will be fully understood from the foregoing description, and it will be apparent that various changes may be made in the form, constructions and arrangement of the exemplary aspects thereof without departing from the scope of the present disclosure or without sacrificing all of its advantageous effects. Because the technique presented herein can be varied in many ways, it will be recognized that the present disclosure should be limited only by the scope of the claims that follow.

## Claims

1. A connector (1) for enabling an electrical connection between a first flexible carrier (21) with electrically conductive tracks (221) on its principal surface and a second flexible carrier (22) with electrically conductive tracks (222) on its principal surface, the connector (1) comprising:
a connector base part (11) having a first planar shape and being configured to accommodate a first surface of the first flexible carrier opposed to the principal surface of the first flexible carrier; and
a connector locking part (12) having a second planar shape and being configured to accommodate a second surface of the second flexible carrier opposed to the principal surface of the second flexible carrier,
wherein, in a closed state of the connector, the electrically conductive tracks of the first and second flexible carriers are urged to contact one another and are fixated in a defined position.

2. The connector of claim 1, wherein:
in an open state of the connector, the first and second flexible carriers are placeable into the defined position.

3. The connector of claim 1 or 2, wherein:
the connector base part comprises a first deformable layer (111) laminated on a first rigid shell layer (112); and
the connector locking part comprises a second deformable layer (121) laminated on a second rigid shell layer (122).

4. The connector of claim 3, wherein:
in the closed state:
- the first deformable layer and the second deformable layer face one another, and
- a respective reactive force of the deformed first and second deformable layers causes the electrically conductive tracks of the first and second flexible carriers to be urged to contact one another.

5. The connector of claim 4, wherein:
in the closed state, the first and second deformable layers define a space in-between them that is dimensioned, in a direction of thickness (z), to press-fit the first and second flexible carriers.

6. The connector of any one of claims 1 to 5, wherein:
the connector base part comprises a first end portion (e1) and a second end portion (e2) opposite to the first end portion,
the connector locking part comprises a third end portion (e3) and a fourth end portion (e4) opposite to the third end portion, and
the connector further comprises a locking mechanism (11sf, 12r, 1h; 11s1, 11s2, 11p1, 11p2) configured to lock, by means of the first to fourth end portions, the connector base part and the connector locking part in the closed state of the connector.

7. The connector of claim 6, wherein the locking mechanism (11sf, 12r, 1h) comprises:
a snap-fit (11sf) comprised in the first end portion, the snap-fit protruding towards the second end portion;
a recess (12r) comprised in the third end portion, the recess being configured to engage with the snap-fit in the closed state of the connector; and
a hinge (1h) consisting of the second end portion and the fourth end portion pivotably engaging one another.

8. The connector of claim 7, when dependent on claim 2, wherein:
in the open state of the connector:
- the snap-fit does not engage with the recess; and
- the hinge is configured to swivel the connector locking part away from the connector base part.

9. The connector of claim 7 or 8, wherein:
the recess has an elongated form; and
the snap-fit has an elongated form substantially matching the elongated form of the recess.

10. The connector of claim 6, wherein the locking mechanism (11s1, 11s2, 11p1, 11p2) comprises:
a first guiding means (11g1, 11s1) comprised in the first end portion;
a second guiding means (11g2, 11s2) parallel to the first guiding means, the second guiding means being comprised in the second end portion;
a first elongated protrusion (11p1) comprised in the third end portion, the first elongated protrusion being configured to slidably engage the first guiding means; and
a second elongated protrusion (11p2) comprised in the fourth end portion, the second elongated protrusion being configured to slidably engage the second guiding means,
wherein the first and second guiding means both are one of a groove (11g1, 11g2) and a setback (11s1, 11s2).

11. The connector of claim 10, wherein:
the connector base part is longer than the connector locking part in a longitudinal direction of the first and second guiding means; and
the connector locking part is slidably movable with respect to the connector base part in a sliding direction parallel to the longitudinal direction.

12. The connector of claim 11, when dependent on claims 2 and 3, wherein:
the first deformable layer covers only a portion of the connector base part; and
in the open state of the connector, the connector locking part is slidably displaced in the sliding direction from the portion of the connector base part covered by the first deformable layer, whereas in the closed state of the connector, the connector locking part is placed above the portion of the connector base part covered by the first deformable layer.

13. The connector of any one of the preceding claims, wherein:
the first and second deformable layers both are pressure-sensitive fleece layers; and/or
the first and second planar shapes of the connector base part and connector locking part mean a rectangular form where both width (x) and length (y) are substantially larger than thickness (z), respectively.

14. The connector of any one of the preceding claims, wherein the first and second flexible carriers both are one of:
a flexible foil; and
a flexible printed circuit, FPC.

15. An aircraft component requiring an electrical connection, the aircraft component comprising at least one connector (1) of any one of the preceding claims.
